# EUROPEAN PATENT APPLICATION

(11) **EP 4 645 691 A1**
(43) Date of publication of application: **05.11.2025**
(21) Application number: 24173982.0
(22) Date of filing: 03.05.2024
(51) Int. Cl.: H03F 3/00, H03F 3/45, H03F 3/70, H03F 1/26, H03F 1/48, H03F 3/387

(54) **CHARGE AMPLIFIER CIRCUIT FOR A CAPACITIVE SENSING ARRANGEMENT**

(71) Applicant: EM Microelectronic-Marin SA, 2074 Marin (CH)
(72) Inventor: FEUCHT, Christian, 2074 Marin (CH)
(74) Representative: ICB SA

(57) **Abstract**

The present disclosure relates to a charge amplifier circuit (10) for a capacitive sensing arrangement (80), the charge amplifier circuit (10) comprising:
- an first amplifier stage (20) comprising a first amplifier input (22), a second amplifier input (23) connectable to the capacitive sensing arrangement (80), and comprising a first amplifier output (24) and a second amplifier output (25),
- a second amplifier stage (30) comprising a first amplifier input (32), a second amplifier input (33), a first amplifier output (34) and a second amplifier output (35), and
- a switched capacitor arrangement (40) between the first amplifier stage (20) and the second amplifier stage (30), the switched capacitor arrangement (40) comprising a first integration capacitor (42), a second integration capacitor (43), a number of first switches (66, 67) and a number of second switches (68, 69).

## Description

### Field of the invention

In one aspect, the present invention relates to a charge amplifier circuit for a capacitive sensing arrangement and to an acceleration sensor comprising such a charge amplifier circuit.

### Background

Capacitive acceleration sensors in MEMS technology require low-noise charge amplifiers in order to convert their output signal into a voltage. Especially for battery-operated devices, a low power consumption is a design goal that contradicts with the requirement for a low noise amplifier. A major problem in the design of such an amplifier results from the fact that a precise settling to the correct output value in a sampled system requires an excessive bandwidth with respect to the sampling frequency. In conventional designs, the total noise contained in this bandwidth is found in the sampled output signal. This phenomenon is known as noise folding. Furthermore, the biasing of a capacitive sensor implies the use of switches that add their thermal noise as the so-called kT/C noise to the signal.

One example of such an approach is described in "A Three-Axis Micromachined Accelerometer with a CMOS Position-Sense Interface and Digital Offset-Trim Electronics" by Lemkin and Boser IEEE Journal of Solid-State Circuits, Vol. 34, No. 4, April 1999, pages 456 - 468. There, a position sensing is described by applying a voltage pulse to the center node of a capacitive bridge. The voltage pulse is made as large as possible to obtain a high signal-to-noise ratio (SNR) at an integrator output. A capacitive imbalance in the bridge circuit causes different amounts of charge to flow from the sense capacitors to the integration capacitors. Effects due to an imbalance of the input capacitances can be cancelled to first order with an input common-mode feedback (ICMFB) circuit. The ICMFB circuit measures the input common mode of the op-amp and applies voltage feedback through two feedback capacitors. The capacitors are chosen to enable a large voltage step. Negative feedback drives the voltage toward a value necessary to keep the input common mode constant. This operation may be thought of as driving both sides of the full bridge, formed by and with voltage pulses chosen for zero input common-mode shift.

However, such solutions are known to have some drawbacks and deficiencies concerning thermal noise and noise folding. It is therefore desirable to provide improvements to charge amplifier circuits for capacitive sensing arrangements, such as capacitive acceleration sensors.

### Summary of the invention

The above-mentioned deficiencies are set aside by a charge amplifier circuit, e.g. by a capacitive acceleration sensor as defined by the features of the independent claims. Numerous examples and embodiments of the invention are subject matter of the dependent claims, respectively.

Accordingly, and in one aspect there is provided a charge amplifier circuit for a capacitive sensing arrangement. The charge amplifier circuit comprises a first amplifier stage. The first amplifier stage comprises a first amplifier input and a second amplifier input, which are both connectable to the capacitive sensing arrangement. The first amplifier stage and hence the first amplifier also comprises a first amplifier output and a second amplifier output.

The charge amplifier circuit further comprises a second amplifier stage. In addition, the second amplifier stage comprises a first amplifier input, a second amplifier input, a first amplifier output and a second amplifier output. Typically, also the second amplifier stage comprises an amplifier.

The charge amplifier circuit further comprises a switched capacitor arrangement located and arranged between the first amplifier stage that comprises a transconductance amplifier and the second amplifier stage. The switched capacitor arrangement comprises a first integration capacitor, a second integration capacitor and a number of first switches and a number of second switches, thus forming a gm-C integrator.

The first integration capacitor is selectively connectable to the first amplifier output of the first amplifier stage by one of the second switches and is selectively connectable to the first amplifier input of the second amplifier stage by one of the first switches.

Also, the second integration capacitor is selectively connectable to the second amplifier output of the first amplifier stage by another one of the second switches and is selectively connectable to the second amplifier input of the second amplifier stage by another one of the first switches.

Typically, first and second switches are switchable or clocked simultaneously. In other words, the first switches are opened or closed simultaneously. Also, the second switches are opened or closed simultaneously. First and second switches may be clocked and/or controlled by a respective clock signal or digital control signal. Typically, the first switches are closed in a first switching phase only, while the second switches are closed in the first and second clock phase.

Specifically, and by closing the first switches the first and second integration capacitors can be connected to the first and second inputs of the second amplifier stage. By opening the first switches, the integration capacitors can be disconnected from the first and second amplifier inputs of the second amplifier stage. Likewise, the first and second integration capacitors can be selectively connected and disconnected to or from the first and the second amplifier outputs of the first amplifier stage by closing or opening the second switches.

The first and the second switches are opened and closed in accordance to predefined clock cycles or phases. By way of example, and when the second switches are closed the first and second integration capacitors can be charged by an output current as provided at the first and second amplifier outputs of the first amplifier stage.

Specifically, in a second phase P2, in which the second switches are closed, an input voltage that may result from a kT/C noise on the first and second amplifier output of the first amplifier stage can be integrated by the first and second integration capacitors.

According to a further example the switched capacitor arrangement also comprises a number of third switches, wherein the second integration capacitor is selectively connectable to the first amplifier output of the first amplifier stage via one of the third switches and wherein the first integration capacitor is selectively connectable to the second amplifier output of the first amplifier stage by another one of the third switches.

Since the kT/C noise at the first amplifier inputs is unchanged in clock phases two and three, the arrangement allows to cancel the kT/C noise.

In a third phase P3, in which the second switches may be opened and the third switches may be closed, an excitation pulse may be applied to the capacitive sensing arrangement.

Specifically, the second switches and the third switches are only and exclusively switchable in an alternating manner. Hence, the second switches can only be opened when the third switches are closed and vice versa. Opening of the second switches may coincide with a closing of the third switches and opening of the third switches may coincide with a closing of the second switches. In this way, it can be achieved that a node of the first and the second integration capacitors is either connected with only one of the first and second amplifier outputs of the first amplifier stage.

Specifically, and when the second switches are closed the first integration capacitor is connected to the first amplifier output of the first amplifier stage and the second integration capacitor is connected to the second amplifier output of the first amplifier stage. By opening the second switches, the first and second integration capacitors are disconnected from the first and second amplifier outputs of the first amplifier stage. Closing the third switches then connects the first amplifier output of the first amplifier stage with the second integration capacitor and further connects the second amplifier output of the first amplifier stage with the first integration capacitor. In this way, an alternating switching of the first and second switches alternatively connects the first and second integration capacitors with the first and the second amplifier outputs of the first amplifier stage, respectively.

According to a further example, the charge amplifier circuit further comprises a first feedback branch and a second feedback branch. The first amplifier output of the second amplifier stage is connectable to the first amplifier input of the first amplifier stage via the first feedback branch. The second amplifier output of the second amplifier stage is connectable to the second amplifier input of the first amplifier stage via the second feedback branch. In this way there can be provided an effective feedback loop from an output of the second amplifier stage to the input of the first amplifier stage.

By way of the feedback loop there can be provided a closed loop charge amplifier arrangement that serves to perform a precise settling over several clock cycles.

According to a further example the first feedback branch comprises a first feedback capacitor in series with another second switch and the second feedback branch comprises a second feedback capacitor in series with a further second switch. In this way, the first and second feedback branches may be interrupted by respective first switches. Accordingly, the feedback capacitors will be charged during a phase P2, during which the second switches are closed.

Moreover, the first and second feedback branches comprise first and second feedback capacitors, respectively. These capacitors provide a delayed feedback during the third phase P3 only. Typically, the gain of the feedback branches and hence of the entire feedback loop, i.e. a respective charge to voltage translation, can be exclusively or only determined by the size of the feedback capacitors.

According to a further example, another second switch is placed between the first feedback capacitor and the first or second amplifier output of the second amplifier stage. The further second switch is arranged between the second feedback capacitor and the second or first amplifier output of the second amplifier stage. In this way and upon closing the other second switch and the further second switch, the feedback capacitors can be charged.

When opening the other second switch and the further second switch, the first and second feedback capacitors are disconnected from the first and second amplifier outputs of the second amplifier stage. However, they may be still connected to the first and second amplifier inputs of the amplifier stage, respectively. Basically, the first feedback capacitor may be permanently connected to the first amplifier input of the first amplifier stage. The second feedback capacitor may be permanently connected to the second amplifier input of the first amplifier stage. In this way and during the phase P3 in which the second switches are open or disconnected, the first and second feedback capacitors may provide a respective feedback voltage to the first and second amplifier inputs of the first amplifier stage.

According to a further example, the first feedback branch comprises a first feedback node between the first feedback capacitor and the other second switch. The second feedback branch comprises a second feedback node between the second feedback capacitor and the further second switch. The first feedback node is connectable to a fixed potential, e.g. an appropriate common mode potential, by another third switch. The second feedback node is connectable to the same fixed potential, by a further third switch.

Since second and third switches are intended to be switched alternately, in phase P2, in which the second switches are closed and the third switches are open, the first and second feedback capacitors can be connected to the first and second amplifier outputs of the second amplifier stage. In phase P3, in which the third switches are closed and the second switches are open, the terminal of the first and second feedback capacitors, which is connectable to the second switches and which is hence connectable to the first and second amplifier outputs of the second amplifier stage can be connected to a fixed potential, e.g. an appropriate common mode potential.

This way, a charge stored in the first and second feedback capacitors during phase P2 can be provided to the first and second amplifier inputs of the first amplifier stage during the phase P3.

According to a further example, the second switches are concurrently switchable by a second control signal P2 and the third switches are concurrently switchable by a third control signal P3, wherein the second switches and the third switches are switchable alternatively. As already mentioned above, the second switches are exclusively to be opened when the third switches are closed; and vice versa, the third switches are to be opened when the second switches are closed.

According to a further example, the second amplifier stage comprises a first feedback branch and a second feedback branch. The first feedback branch connects the first amplifier output of the second amplifier stage with the first amplifier input of the second amplifier stage. The first feedback branch further comprises a third integration capacitor.

Further, the second feedback branch connects the second amplifier output of the second amplifier stage with the second amplifier input of the second amplifier stage. Also, the second feedback branch comprises a fourth integration capacitor.

The third and fourth integration capacitors provide another second amplifier stage-specific or second amplifier stage-internal feedback loop, which is capable to produce or to store a voltage during one of the phases of a clock cycle. This feedback loop is configured to provide a respective voltage during another phase of the clock cycle.

According to a further example, the first amplifier stage comprises a first amplifier. The first amplifier comprises the first amplifier input as already mentioned above. The first amplifier further comprises the second amplifier input as described above. The first amplifier also comprises the first amplifier output and the second amplifier output of the first amplifier stage as described above.

Furthermore, the first amplifier stage comprises a first feedback branch connecting the first amplifier output of the first amplifier with the third amplifier input of the first amplifier. The first amplifier stage also comprises a second feedback branch connecting the second amplifier output of the first amplifier with a fourth amplifier input of the first amplifier.

In addition, the first amplifier stage comprises a first holding capacitor and another first switch in the first feedback branch of the first amplifier stage and further comprises a second holding capacitor and a further first switch in the second feedback branch of the first amplifier stage.

Another first switch and the further first switch are switchable or closable during the first phase P1 of the clock cycle. During the first phase P1, the first and second holding capacitors may be charged. By opening the first switches during another phase of the clock cycle, the first and second holding capacitors may provide a respective offset voltage to the third and fourth amplifier inputs of the first amplifier of the first amplifier stage.

In this way, there can be provided an offset input voltage to the first amplifier of the first amplifier stage, e.g. operable to compensate or to eliminate any kT/C noise.

According to a further example, the first feedback branch of the first amplifier stage comprises a first node between another first switch and the third amplifier input. The second feedback branch of the first amplifier stage comprises a second node between the further first switch and the fourth amplifier input. This way, the first and second node may be permanently connected to the third and fourth amplifier inputs of the first amplifier of the first amplifier stage, respectively. The first and second node may be disconnected by another first switch and the further first switch from the respective amplifier output of the first amplifier stage.

According to another example the first holding capacitor is connected to the first node of the first feedback branch by a first terminal and is connected to a fixed potential, e.g. to ground, with another terminal. The second holding capacitor is connected to the second node of the second feedback branch via a first terminal and is further connected to a fixed potential, e.g., to ground, with another terminal. In this way, it can be provided that the first and second holding capacitors provide an offset voltage to the third and fourth amplifier inputs of the first amplifier of the first amplifier stage when the other first switch and the further first switch are opened or disconnected.

During the phase P1, in which the first switches and hence the other first switch and the further first switch are closed, the respective first and second holding capacitors can be charged by the output voltage provided at the first and second amplifier outputs of the first amplifier of the first amplifier stage.

The first control signal is switched off and hence returns from a logical one to a logical zero before the second control signal returns to a logical zero.

According to another example and in a clock cycle, the first and second switches are concurrently transferable into a closed state and the first switches are concurrently switchable into an open state prior to the second switches are concurrently switchable into an open state. In this way, the first phase P1 may be used as a kind of a reset phase. During the second phase P2, an input voltage that may result from the kT/C noise may be integrated by the combination of the first amplifier that is implemented as a transconductance amplifier and the integration capacitors of the switched capacitor arrangement.

In a subsequent phase P3, an excitation pulse may be applied to the capacitive sensing arrangement thus generating a charge that may be equivalent to an acceleration of the capacitive sensing arrangement. This charge may be then compensated by the first and the second feedback capacitors that may be charged with the output voltage of the second amplifier stage in a previous clock cycle.

During phase P3, the input voltage is integrated again by a combination of the first amplifier stage and the integration capacitor of the switched capacitor arrangement but with the capacitors connected in opposite polarity. This change in polarity leads to a cancellation of a stored charge that is proportional to the kT/C noise. At the end of the third phase P3, the integration capacitors of the switched capacitor arrangement are configured to hold a charge that is proportional to the error voltage only. This charge is then transferred to the second amplifier of the second amplifier stage and the third and fourth feedback capacitors of the respective feedback branches of the second amplifier stage in a reset phase P1 of a subsequent clock cycle. The entire charge amplifier circuit may act as a closed loop charge amplifier that compensates the kT/C noise at the input of the first amplifier stage while performing a precise settling over several clock cycles.

Typically, a large offset of the first amplifier of the first amplifier stage would compromise the dynamic range of the integrator formed by the first amplifier and the first and second integration capacitors. Therefore, the first amplifier of the first amplifier stage is equipped with offset-compensating inputs. In the reset phase P1 the first amplifier of the first amplifier stage operates in a closed loop configuration, storing its offset on the first and second holding capacitors. Even though the voltage that is held on the holding capacitors may be contaminated by a folded noise of the first amplifier, it does not affect the output signal as it is subjected to the double integration that eliminates any constant signal.

According to another aspect, the present invention also relates to a capacitive acceleration sensor. The capacitive acceleration sensor comprises a capacitive sensing arrangement and a charge amplifier circuit as described above, which is connected to the capacitive sensing arrangement and which serves to amplify the charge as provided by the capacitive sensing arrangement in response to an acceleration. Insofar and since the capacitive acceleration sensor comprises a charge amplifier circuit as described above, all features, effects and benefits as described above in connection with the charge amplifier circuit equally apply to the capacitive acceleration sensor.

### Brief description of the drawings

In the following numerous examples of the invention will be described in greater detail by making reference to the drawings, in which:
- Fig. 1 shows a block diagram of the charge amplifier circuit and the capacitive acceleration sensor, and
- Fig. 2 shows a timing diagram for switching the individual switches of the charge amplifier circuit in accordance to Fig. 1.

### Detailed description of the invention

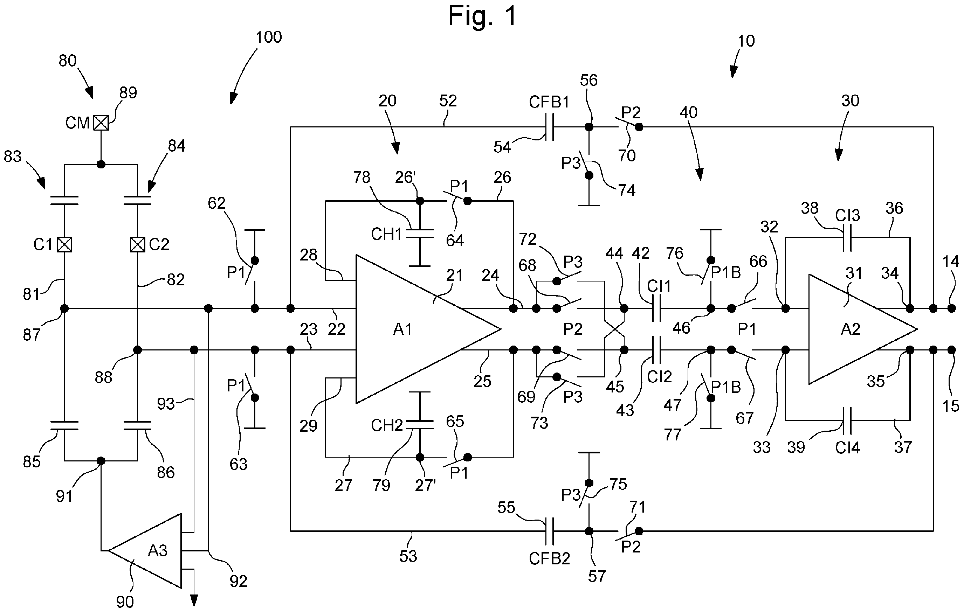

In Fig. 1 there is illustrated an example of a capacitive sensing arrangement 80 connected or coupled to a charge amplifier circuit 10. The charge amplifier circuit 10 that is connected to the capacitive sensing arrangement 80 forms or constitutes an acceleration sensor 100.

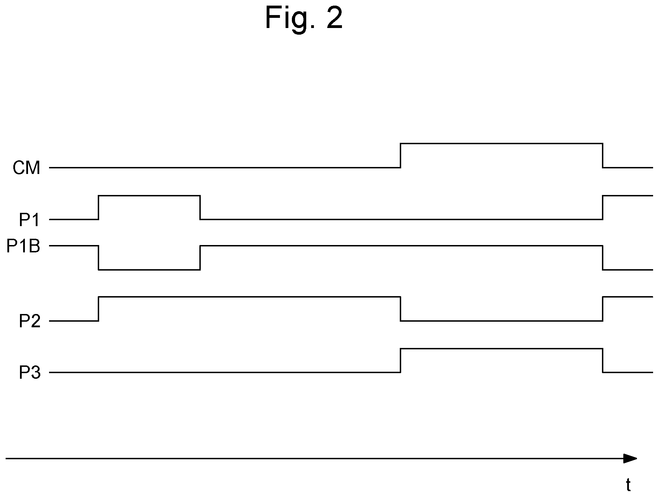

The capacitive sensing arrangement 80 comprises an input 89, through which a pulse signal CM as shown in Fig. 2 can be provided to the capacitive sensing arrangement 80. The capacitive sensing arrangement 80 comprises a first sensing branch 81 and a second sensing branch 82 that are parallel to each other. The first and the second sensing branches 81, 82 are both connected to the input 89. The first sensing branch 81 comprises a first sensing capacitor 83 and a first common mode feedback capacitor 85 that are connected in series. The second sensing branch 82 comprises a first sensing capacitor 84 and a second common mode feedback capacitor 86 also connected in series. The first and second sensing capacitors 83, 84 are both connected via one terminal to the input 89. An opposite terminal of the first and second sensing capacitors 83, 84 is connected with a first terminal of the respective first and second common mode feedback capacitors. An opposite terminal of the first and the second common mode feedback capacitor is connected to an output 91 of an input common mode regulator stage 90.

The first sensing branch 81 comprises a first node 87 located between the first sensing capacitor 83 and the first common mode feedback capacitor 85. The second feedback branch 82 comprises a second node 88 located between the second sensing capacitor 84 and the second common mode feedback capacitor 86. The input common mode feedback stage 90 comprises a first input 92 connected to the first node 87. The input common mode feedback stage 90 further comprises a second input 93 connected to the second node 88. The common mode feedback capacitors 85, 86 and the sensing capacitors 83, 84 form or constitute a sensing bridge by way of which there can be implemented a differential charge integrator. The charge amplifier circuit 10 connected or connectable to the sensing arrangement 80 comprises a first amplifier stage 20 and a second amplifier stage 30 as well as a switched capacitor arrangement 40 between the first amplifier stage 20 and the second amplifier stage 30.

The first amplifier stage 20 comprises a first transconductance amplifier 21. The first amplifier 21 comprises a first amplifier input 22 and a second amplifier input 23. The first amplifier input 22 is connected to the first node 87 and the second amplifier input 23 is connected to the second node 88.

Furthermore, there are provided first switches 62, 63, each of which connected to the first and to the second amplifier inputs 22, 23 of the first amplifier 21 with one terminal and being further connected to a fixed potential that is an appropriate common mode potential with another terminal. By closing the first switches 62, 63 the first and second amplifier inputs 22, 23 can be connected to the fixed common mode potential. In this way, there can be provided a reset of the charge amplifier circuit 10 during a phase P1, i.e. during which the first switches 62, 63 are closed.

The first amplifier stage 20 comprises a first feedback branch 26 and a second feedback branch 27. The first amplifier 21 further comprises a first amplifier output 24 and a second amplifier output 25. The first feedback branch 26 is operable to connect the first amplifier output 24 with a third amplifier input 28. The second feedback branch 27 is operable to connect the second amplifier output 25 with a fourth amplifier input 29. Both, the first and the second feedback branches 26, 27 are provided with another first switch 64 and with a further first switch 65, respectively.

By way of the switches 64, 65 the respective feedback branches 26, 27 can be interrupted. Specifically. and by closing the switches 64, 65 the feedback branches 26, 27 can be closed, thereby interconnecting the first amplifier output 24 with the third amplifier input 28 and interconnecting the second amplifier output 25 with the fourth amplifier input 29.

The first feedback branch 26 further comprises a first node 26'. The second feedback branch 27 comprises a second node 27'. The first node 26' is connected with one terminal of a first holding capacitor 78. The second node 27' is connected with a first terminal of a second holding capacitor 79. Opposite terminal of the first and the second holding capacitor 78, 79 may be connected to a fixed potential, e.g., to ground. Specifically, the first node 26' is permanently connected to the third amplifier input 28. The second node 27' is permanently connected to the fourth amplifier input 29.

During a reset phase, i.e. during the phase P1, during which the first switches 62, 63, 64, 65 and further first switches 66, 67 are concurrently closed, the first amplifier stage 20 can be driven in a reset mode by way of which the first and second amplifier inputs 22, 23 may be shortened to the common mode voltage as provided by an appropriate common mode voltage source. In this way there is provided a required DC bias to the respective input nodes.

The second amplifier stage 30 comprises a second amplifier 31. The second amplifier 31 and hence the second amplifier stage 30 comprises a first amplifier input 32 and a second amplifier input 33 as well as a first amplifier output 34 and a second amplifier output 35. The second amplifier stage 30 comprises a first feedback branch 36 by way of which the first amplifier output 34 is connected to the first amplifier input 32. There is further provided a second feedback branch 37 by way of which the second amplifier output 35 is connected to the first amplifier input 33.

The feedback branches 36, 37 each comprise an integration capacitor 38, 39. Specifically, the first feedback branch 36 comprises a third integration capacitor 38 and the second feedback branch 37 comprises a fourth integration capacitor 39. Hence, the first amplifier output 34 is connected to the first amplifier input 32 via the third integration capacitor 38. The second amplifier output 35 is connected to the second amplifier input 33 via the fourth integration capacitor 39.

The switched capacitor arrangement 40 located between the first amplifier stage 20 and the second amplifier stage 30 comprises a first integration capacitor 42 and a second integration capacitor 43. The switched capacitor arrangement 40 further comprises numerous second and third switches 68, 69, 72, and 73, respectively.

The switched capacitor arrangement 40 comprises two second switches 68, 69 and 2 third switches 72, 73 that are switchable concurrently or simultaneously, respectively.

The second switch 68 is located between the first amplifier output 24 and the first integration capacitor 42. The further second switch 69 is connected or located between the second amplifier output 25 and the second integration capacitor 43. The third switch 72 is located between the first amplifier output 24 and the second integration capacitor 43 and the further third which 73 is located between the second amplifier output 25 and the first integration capacitor 42. The second switches 68, 69 are alternately switchable in accordance to the control signal P2 relative to the third switches 72, 73, which are controllable by the control signal P3, as will be apparent from the switching diagram of Fig. 2.

The first integration capacitor 42 comprises a first terminal, which is selectively connectable to the first amplifier output 24 via the second switch 68 and with the second and amplifier output 25 via the third switch 73. Likewise, a first terminal of the second integration capacitor 43 is selectively connectable to the second amplifier output 25 via the second switch 69 and is connectable to the first amplifier output 24 via the third switch 72. In this way, the respective terminal of the first and the second integration capacitors 42, 43 is alternately and interchangeably connectable to the first amplifier output 24 and to the second amplifier output 25.

An opposite terminal of the first and the second integration capacitors 42, 43 is connectable to the first amplifier input 32 and to the second amplifier input 33 of the second amplifier 31 of the second amplifier stage 30 via first switches 66, 67. By closing the first switches 66, 67 the first integration capacitor 42 can be connected to the first amplifier input 32 and the second integration capacitor 43 can be connected to the second amplifier input 33.

Moreover, there is provided a node 46 between the first switch 66 and the first integration capacitor 42. There is provided another node 47 between the first switch 67 and the second integration capacitor 43. The first node 46 is connectable to a fixed common mode potential, via a first switch 76. The further node 47 is connectable to the same fixed common mode potential, via another first switch 77. The first switches 76, 77 are controllable by a control signal P1B, which is an inverted signal of the first control signal P1 as will be apparent from the switching or timing diagram of Fig. 2.

The charge amplifier circuit 10 further comprises a first feedback branch 52 and a second feedback branch 53, by way of which the first and second amplifier outputs 34, 35 of the second amplifier 31 can be connected to first and second amplifier inputs 22, 23 of the first amplifier 21. The first feedback branch 52 comprises another second switch 70 in series with a first feedback capacitor 54. The second feedback branch 53 comprises a further second switch 71 in series with a second feedback capacitor 55. The first and second feedback capacitors 54, 55 each comprise a terminal that is permanently connected to the first and to the second amplifier inputs 22, 23, respectively. The first and the second feedback capacitors 54, 55 each comprise another terminal that is connected to another second switch 70 or to the further second switch 71.

Between the second switch 70 and the first feedback capacitor 54 there is provided a node 56. Between the second feedback capacitor 55 and the further second switch 71 there is provided a node 57. The node 56 is connectable to a fixed common mode potential, via another third switch 74. The node 57 is connectable to the same fixed common mode potential via a further third switch 75.

Operation of the charge amplifier circuit is controlled by the numerous control signals P1, P2, P3 and P1B by way of which the first switches 62, 63, 64, 65, 66, 67, the second switches 68, 69, 70, 71 the third switches 72, 73, 74, 75 and the switches 76, 77 can be switched simultaneously. The switches 76, 77 are switchable by the control signal P1B. The first switches 62, 63, 64, 65, 66, 67, can be exclusively switched by the first control signal P1, the second switches 68, 69, 70, 71 can be exclusively switched by the second control signal P2 and the third switches 72, 73, 74, 75 can be exclusively switched by the third control signal P3.

During a first Phase P1 of a clock cycle as shown in Fig. 2 and hence when all first switches 62, 63, 64, 65, 66, 67, are simultaneously closed, the output of the capacitive sensing arrangement 80 is shortened to a common mode voltage, providing a required DC bias to these nodes. The phase P1 temporally overlaps with the phase P2. In phase P2, an input voltage that results from a kT/C noise on the input nodes is integrated by the combination of the first amplifier 21 and the first and second integration capacitors 42, 43.

In the subsequent phase P3, an excitation pulse CM can be applied to the sensing arrangement 80, thereby generating a charge that may be equivalent to an acceleration of the acceleration sensor 100. This charge can be compensated by the feedback capacitors 54, 55 that are charged with the output voltage from a previous clock cycle. If a complete settling should not yet be achieved, an error voltage will be added on the input node that still holds the kT/C noise from the first phase P1.

This input voltage is integrated by the combination of the transconductance amplifier A1 and the integration capacitors 42, 43 during phase P2.

This input voltage is integrated again but with opposite polarity by the combination of the transconductance amplifier A1 and the integration capacitors 42, 43 during phase P3, where the first and second integration capacitors 42, 43 are connected in opposite polarity with the first and the second amplifier outputs 24, 25 as compared with the situation in phase P2.

The change in polarity leads to a cancellation of the charge previously stored, which is proportional to the kT/C noise. Thus, and at the end of phase P3 the integration capacitors 42, 43 hold a charge that is proportional to the error voltage only.

In a subsequent phase P1 of the next clock cycle, this charge is transferred to the integrator, which is constituted or formed by the second amplifier 31 and the third and fourth integration capacitors 38, 39.

The entire charge amplifier circuit 10 acts as a closed loop charge amplifier that compensates the kT/C noise on the input nodes 22, 23 while performing a precise settling over several clock cycles. Here, the gain of the loop, i.e. the charge to voltage translation, is determined by the feedback capacitors 54, 55 only.

A large offset of the first amplifier 21 may compromise the dynamic range of the integrator formed or constituted by the first amplifier 21 and the integration capacitors 42, 43. Therefore, the first amplifier 21 is provided with offset compensation inputs. Here and in the reset phase P1, the first amplifier 21 is operated in a closed loop configuration, storing its offsets on the holding capacitors 78, 79. Even though the voltage signal that is held on the capacitors 78, 79 may be contaminated by the folded noise of the first amplifier 21, it does not affect the output signal as the output signal is subject to a double integration that is configured to eliminate any constant signal.

### Nomenclature

- 10: charge amplifier
- 14: output
- 15: output
- 20: amplifier stage
- 21: first amplifier
- 22: amplifier input
- 23: amplifier input
- 24: amplifier output
- 25: amplifier output
- 26: feedback branch
- 26': node
- 27: feedback branch
- 27': node
- 28: amplifier input
- 29: amplifier input
- 30: amplifier stage
- 31: amplifier
- 32: amplifier input
- 33: amplifier input
- 34: amplifier output
- 35: amplifier output
- 36: feedback branch
- 37: feedback branch
- 38: integration capacitor
- 39: integration capacitor
- 40: switched capacitor arrangement
- 42: integration capacitor
- 43: integration capacitor
- 44: terminal
- 45: terminal
- 46: terminal
- 47: terminal
- 52: feedback branch
- 53: feedback branch
- 54: feedback capacitor
- 55: feedback capacitor
- 56: node
- 57: node
- 62: switch
- 63: switch
- 64: switch
- 65: switch
- 66: switch
- 67: switch
- 68: switch
- 69: switch
- 70: switch
- 71: switch
- 72: switch
- 73: switch
- 74: switch
- 75: switch
- 76: switch
- 77: switch
- 80: sensing arrangement
- 81: sensing branch
- 82: sensing branch
- 83: sensing capacitor
- 84: sensing capacitor
- 85: common mode feedback capacitor
- 86: common mode feedback capacitor
- 87: node
- 88: node
- 89: input
- 90: input common mode feedback stage
- 91: output
- 92: common mode input
- 93: common mode input
- 100: acceleration sensor

## Claims

1. A charge amplifier circuit (10) for a capacitive sensing arrangement (80), the charge amplifier circuit (10) comprising:
- a first amplifier stage (20) comprising a first amplifier input (22), a second amplifier input (23) connectable to the capacitive sensing arrangement (80), and comprising a first amplifier output (24) and a second amplifier output (25),
- a second amplifier stage (30) comprising a first amplifier input (32), a second amplifier input (33), a first amplifier output (34) and a second amplifier output (35), and
- a switched capacitor arrangement (40) between the first amplifier stage (20) and the second amplifier stage (30), the switched capacitor arrangement (40) comprising a first integration capacitor (42), a second integration capacitor (43), a number of first switches (66, 67) and a number of second switches (68, 69),
- wherein the first integration capacitor (42) is selectively connectable to the first amplifier output (24) of the first amplifier stage (20) via one of the second switches (68) and is selectively connectable to the first amplifier input (32) of the second amplifier stage (30) via one of the first switches (66), and
- wherein the second integration capacitor (43) is selectively connectable to the second amplifier output (25) of the first amplifier stage (20) via another one of the second switches (69) and is selectively connectable to the second amplifier input (33) of the second amplifier stage (30) via another one of the first switches (67).

2. The charge amplifier circuit (10) according to claim 1, wherein the switched capacitor arrangement (40) further comprises a number of third switches (72, 73),
- wherein the second integration capacitor (43) is selectively connectable to the first amplifier output (24) of the first amplifier stage (20) via one of the third switches (72), and
- wherein the first integration capacitor (42) is selectively connectable to the second amplifier output (25) of the first amplifier stage (20) via another one of the third switches (73).

3. The charge amplifier circuit (10) according to any one of the preceding claims, further comprising a first feedback branch (52) and a second feedback branch (53),
- wherein the first amplifier output (34) of the second amplifier stage (30) is connectable to the first amplifier input (22) of the first amplifier stage (20) via the first feedback branch (52), and
- wherein the second amplifier output (35) of the second amplifier stage (30) is connectable to the second amplifier input (23) of the first amplifier stage (20) via the second feedback branch (53).

4. The charge amplifier circuit (10) according to claim 3, wherein the first feedback branch (52) comprises a first feedback capacitor (54) in series with another second switch (70) and wherein second feedback branch (53) comprises a second feedback capacitor (55) in series with a further second switch (71).

5. The charge amplifier circuit (10) according to claim 4, wherein another second switch (70) is arranged between the first feedback capacitor (54) and the first amplifier output (34) of the second amplifier stage (30) and wherein the further second switch (71) is arranged between the second feedback capacitor (55) and the second amplifier output (35) of the second amplifier stage (30).

6. The charge amplifier circuit (10) according to claim 4 or 5, wherein the first feedback branch (52) comprises a first feedback node (56) between the first feedback capacitor (54) and the another second switch (70) and wherein the second feedback branch (53) comprises a second feedback node (57) between the second feedback capacitor (55) and the further second switch (71),
- wherein the first feedback node (56) is connectable to a fixed potential via another third switch (74) and
- wherein the second feedback node (57) is connectable to a further fixed potential via a further third switch (75).

7. The charge amplifier circuit (10) according to any one of the preceding claims, wherein the second switches (68, 69, 70, 71) are concurrently switchable by a second control signal (P2) and wherein the third switches (72, 73, 74, 75) are concurrently switchable by a third control signal (P3) and wherein the second switches (68, 69, 70, 71) and the third switches (72, 73, 74, 75) are switchable alternately.

8. The charge amplifier circuit (10) according to any one of the preceding claims, wherein the second amplifier stage (30) comprises a first feedback branch (36) and a second feedback branch (37),
- wherein the first feedback branch (36) connects the first amplifier output (34) of the second amplifier stage (30) with the first amplifier input (32) of the second amplifier stage (30) and comprises a third integration capacitor (38),
- wherein the second feedback branch (37) connects the second amplifier output (35) of the second amplifier stage (30) with the second amplifier input (33) of the second amplifier stage (30) and comprises a fourth integration capacitor (39).

9. The charge amplifier circuit (10) according to any one of the preceding claims, wherein the first amplifier stage (20) comprises:
- a first amplifier (21) comprising the first amplifier input (22), the second amplifier input (23), the first amplifier output (24) and the second amplifier output (25) of the first amplifier stage (20),
- a first feedback branch (26) connecting the first amplifier output (24) of the first amplifier (21) with a third amplifier input (28) of the first amplifier (20),
- a second feedback branch (27) connecting the second amplifier output (25) of the first amplifier (21) with a fourth amplifier input (29) of the first amplifier (20), and
- a first holding capacitor (78) and another first switch (64) in the first feedback branch (26) of the first amplifier stage (20), and
- a second holding capacitor (79) and a further first switch (65) in the second feedback branch (27) of the first amplifier stage (20).

10. The charge amplifier circuit (10) according to claim 9, wherein the first feedback branch (26) of the first amplifier stage (20) comprises a first node (26') between another first switch (64) and the third amplifier input (28) and wherein the second feedback branch (27) of the first amplifier stage (20) comprises a second node (27') between the further first switch (65) and the fourth amplifier input (29).

11. The charge amplifier circuit (10) according to claim 10, wherein the first holding capacitor (78) is connected to the first node (26') of the first feedback branch (26) via a first terminal and is connected to a fixed potential with another terminal, and wherein second holding capacitor (79) is connected to the second node (27') of the second feedback branch (27) via a first terminal and is connected to a fixed potential with another terminal.

12. The charge amplifier circuit (10) according to any one of the preceding claims, wherein the first amplifier input (22) of the first amplifier stage (20) is selectively connectable to a fixed potential via another first switch (62) and wherein the second amplifier input (23) of the first amplifier stage (20) is selectively connectable to the same fixed potential via another first switch (63).

13. The charge amplifier circuit (10) according to any one of the preceding claims, wherein the first switches (62, 63, 64, 65, 66, 67) are concurrently switchable by a first control signal (P1).

14. The charge amplifier circuit (10) according to any one of the preceding claims, wherein in a clock cycle the first switches (62, 63, 64, 65, 66, 67) and the second switches (68, 69, 70, 71) are concurrently transferrable into a closed state and wherein the first switches (62, 63, 64, 65, 66, 67) are concurrently switchable into an open state prior to closing the second switches (68, 69, 70, 71) that are concurrently switchable into an open state.

15. A capacitive acceleration sensor (100) comprising:
- a capacitive sensing arrangement (80), and
- a charge amplifier circuit (10) according to any one of the preceding claims and connected to the capacitive sensing arrangement (80).
